(19) **Europäisches Patentamt**
**European Patent Office**
**Office européen des brevets**

(11) **EP 4 458 999 A1**

(12) **EUROPEAN PATENT APPLICATION**
published in accordance with Art. 153(4) EPC

(43) Date of publication:
**06.11.2024 Bulletin 2024/45**

(21) Application number: **22916077.5**

(22) Date of filing: **27.12.2022**

(51) International Patent Classification (IPC):
*C22C 9/00* (2006.01)    *C22F 1/00* (2006.01)
*C22F 1/08* (2006.01)

(52) Cooperative Patent Classification (CPC):
**C22C 9/00; C22F 1/00; C22F 1/08**

(86) International application number:
**PCT/JP2022/048118**

(87) International publication number:
**WO 2023/127854 (06.07.2023 Gazette 2023/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.12.2021 JP 2021214029**

(71) Applicant: **Mitsubishi Materials Corporation Tokyo 100-8117 (JP)**

(72) Inventors:
• **MATSUNAGA, Hirotaka**
  **Aizuwakamatsu-shi,**
  **Fukushima 965-8522 (JP)**
• **MORIKAWA, Kenji**
  **Aizuwakamatsu-shi,**
  **Fukushima 965-8522 (JP)**
• **FUNAKI, Shinichi**
  **Aizuwakamatsu-shi,**
  **Fukushima 965-8522 (JP)**
• **FUKUOKA, Kosei**
  **Kitamoto-shi,**
  **Saitama 364-0028 (JP)**
• **ITO, Yuki**
  **Kitamoto-shi,**
  **Saitama 364-0028 (JP)**
• **MAKI, Kazunari**
  **Kitamoto-shi,**
  **Saitama 364-0028 (JP)**

(74) Representative: **Hoffmann Eitle Patent- und Rechtsanwälte PartmbB Arabellastraße 30 81925 München (DE)**

(54) **COPPER ALLOY, PLASTIC WORKED COPPER ALLOY MATERIAL, COMPONENT FOR ELECTRONIC/ELECTRICAL DEVICES, TERMINAL, BUS BAR, LEAD FRAME, AND HEAT DISSIPATION SUBSTRATE**

(57)    This copper alloy having a high electrical conductivity and excellent heat resistance includes Mg in an amount of greater than 10 mass ppm and 100 mass ppm or less with a balance being Cu and inevitable impurities, an amount of S is 10 mass ppm or less, an amount of P is 10 mass ppm or less, an amount of Se is 5 mass ppm or less, an amount of Te is 5 mass ppm or less, an amount of Sb is 5 mass ppm or less, an amount of Bi is 5 mass ppm or less, an amount of As is 5 mass ppm or less, a total amount of S, P, Se, Te, Sb, Bi, and As is 30 mass ppm or less, a mass ratio [Mg]/[S + P + Se + Te + Sb + Bi + As] is 0.6 or greater and 50 or less, an electrical conductivity is 97% IACS or greater, an average value of orientation densities at $\varphi2 = 0°$, in a range of $\varphi1 = 0°$ to 20°, and in a range of $\Phi = 35°$ to 55° is 1.3 or greater and less than 20.0, and an area ratio of crystals having a crystal orientation of 10° or less with respect to an S orientation { 123 }<634> is 10% or less.

EP 4 458 999 A1

**Description**

[Technical Field]

The present invention relates to a copper alloy suitable for a component for electronic and electrical devices, such as a terminal, a bus bar, a lead frame, or a heat dissipation substrate, a plastically-worked copper alloy material, a component for electronic and electrical devices, a terminal, a bus bar, a lead frame, and a heat dissipation substrate which include the copper alloy.

The present application claims priority on Japanese Patent Application No. 2021-214029 filed on December 28, 2021, the content of which is incorporated herein by reference.

[Background Art]

In the related art, copper or a copper alloy with high conductive properties has been used as a component for electronic and electrical devices such as a terminal, a bus bar, a lead frame, or a heat dissipation member.

In response to an increase in the current in electronic devices, electrical devices, or the like, attempts have been made to increase the sizes and thicknesses of components for electronic and electrical devices that are used for the electronic devices, electrical devices, or the like in order for a decrease in the current density and the diffusion of heat attributed to Joule heat generation.

In order to deal with a large current, a pure copper material such as oxygen-free copper having an excellent electrical conductivity is applied to the components for electronic and electrical devices described above. However, with heat generation during energization and a temperature increase in the usage environment, the copper material is required to have excellent heat resistance representing the resistance to hardness decrease at high temperatures, but the pure copper material is inferior in the above-described properties and cannot be used in high temperature environments.

Thus, Patent Document 1 discloses a rolled copper sheet including 0.005 mass% or greater and less than 0.1 mass% of Mg.

The rolled copper sheet described in Patent Document 1 has a composition including 0.005 mass% or greater and less than 0.1 mass% of Mg with a balance being Cu and inevitable impurities, and thus the strength and the heat resistance can be improved by forming solid solutions of Mg in the matrix of copper without a significant decrease in the electrical conductivity.

[Citation List]

[Patent Document]

[Patent Document 1]
Japanese Unexamined Patent Application, First Publication No. 2016-056414

[Summary of Invention]

[Technical Problem]

In these materials, since the heat resistant properties are improved by adding a solute element, the electrical conductivity is inferior to that of pure copper.

Recently, a copper material constituting the component for electronic and electrical devices is required to further improve the electrical conductivity in order to sufficiently suppress heat generation in a case where a large current flows, and in order to be usable for applications where the pure copper material has been used.

Further, since the above-described component for electronic and electrical devices is frequently used in high temperature environments such as an engine room, the copper material constituting the component for electronic and electrical devices is required to improve the heat resistance more than before. That is, there is a demand for a copper material with improved electrical conductivity and heat resistance in a well-balanced manner.

The present invention has been made in view of the above-described circumstances, and an object thereof is to provide a copper alloy, a plastically-worked copper alloy material, a component for electronic and electrical devices, a terminal, a bus bar, a lead frame, and a heat dissipation substrate, which have a high electrical conductivity and excellent heat resistance.

[Solution to Problem]

The present inventors have conducted intensive studies in order to solve the problems, and as a result, found that, in order to achieve both a high electrical conductivity and excellent heat resistance in a well-balanced manner, a small amount of Mg is added, the amount of an element that generates a compound with Mg is regulated, and the structure is controlled according to the composition, so that it is possible to improve the electrical conductivity and the heat resistance in a well-balanced manner to a higher level than in the related art.

The present invention has been made based on the above-described findings, and a copper alloy according to the present invention is a copper alloy having a composition including Mg in an amount of greater than 10 mass ppm and 100 mass ppm or less with a balance being Cu and inevitable impurities, in which in the inevitable impurities, an amount of S is 10 mass ppm or less, an amount of P is 10 mass ppm or less, an amount of Se is 5 mass ppm or less, an amount of Te is 5 mass ppm or less, an amount of Sb is 5 mass ppm or less, an amount of Bi is 5 mass ppm or less, an amount of As is 5 mass ppm or less, and a total amount of S, P, Se, Te, Sb, Bi, and As is 30 mass ppm or less, when the amount of Mg is indicated as [Mg] and the total amount of S, P, Se, Te, Sb, Bi, and As is indicated as [S + P + Se + Te + Sb + Bi + As], a mass ratio thereof [Mg]/[S + P + Se + Te + Sb + Bi + As] is in a range of 0.6 or greater and 50 or less, an electrical conductivity is 97% IACS or greater, when a crystal orientation distribution function obtained from texture analysis by an EBSD method is expressed in terms of Euler angles, an average value of orientation densities at $\varphi 2 = 0°$, in a range of cp 1 = 0° to 20°, and in a range of $\Phi = 35°$ to 55° is 1.3 or greater and less than 20.0, and an area ratio of crystals having a crystal orientation of 10° or less with respect to an S orientation { 123 }<634> is 10% or less.

According to the copper alloy having the above-described configuration, the amount of Mg and the amounts of S, P, Se, Te, Sb, Bi, and As, that are the elements generating compounds with Mg, are defined as described above. Accordingly, Mg added in a small amount forms solid solutions of Mg in the matrix of copper, and thus the heat resistance can be improved without a significant decrease in the electrical conductivity. Specifically, the electrical conductivity can be set to be 97% IACS or greater.

In addition, since the crystal structure is controlled so that the orientation density and the S orientation are in the above-described ranges, recovery or recrystallization by the movement of dislocations is unlikely to occur, and the heat resistance can be sufficiently improved.

In the copper alloy according to the present invention, it is preferable that an amount of Ag be in a range of 5 mass ppm or greater and 20 mass ppm or less.

In this case, since the amount of Ag is in the above-described range, Ag segregates in the vicinity of grain boundaries and grain boundary diffusion is suppressed, so that the heat resistance can be further improved.

In addition, in the copper alloy according to the present invention, it is preferable that a heatproof temperature be 260°C or higher.

In this case, since the heatproof temperature is 260°C or higher, the heat resistance is sufficiently excellent, and the copper alloy can be stably used even in high temperature environments.

A plastically-worked copper alloy material according to the present invention includes the above-described copper alloy.

According to the plastically-worked copper alloy material having the above-described configuration, since the plastically-worked copper alloy material includes the above-described copper alloy, the plastically-worked copper alloy material has excellent conductive properties and heat resistance, and is particularly suitable as a material for a component for electronic and electrical devices, such as a terminal, a bus bar, a lead frame, or a heat dissipation substrate that is used for large current applications in high temperature environments.

The plastically-worked copper alloy material according to the present invention may be a multi-gauge strip.

In this case, it is possible to sufficiently ensure the heat resistance even in a case where strong working is performed to form a multi-gauge strip with varying thicknesses in a cross section orthogonal to a longitudinal direction.

In addition, it is preferable that the plastically-worked copper alloy material according to the present invention includes a metal plating layer on a surface.

In this case, since the plastically-worked copper alloy material includes the metal plating layer on the surface, the plastically-worked copper alloy material is particularly suitable as a material for a component for electronic and electrical devices such as a terminal, a bus bar, a lead frame, or a heat dissipation member.

A component for electronic and electrical devices according to the present invention includes the above-described plastically-worked copper alloy material.

Further, examples of the component for electronic and electrical devices according to the present invention include a terminal, a bus bar, a lead frame, a heat dissipation substrate, and the like.

Since the component for electronic and electrical devices having the above-described configuration is manufactured by using the above-described plastically-worked copper alloy material, the component for electronic and electrical devices can exhibit excellent properties even in large current applications and high temperature environments.

A terminal according to the present invention includes the above-described plastically-worked copper alloy material.

Since the terminal having the above-described configuration is manufactured by using the above-described plastically-worked copper alloy material, the terminal can exhibit excellent properties even in large current applications and high temperature environments.

A bus bar according to the present invention includes the above-described plastically-worked copper alloy material.

Since the bus bar having the above-described configuration is manufactured by using the above-described plastically-worked copper alloy material, the bus bar can exhibit excellent properties even in large current applications and high temperature environments.

A lead frame according to the present invention includes the above-described plastically-worked copper alloy material.

Since the lead frame having the above-described configuration is manufactured by using the above-described plastically-worked copper alloy material, the lead frame can exhibit excellent properties even in large current applications and high temperature environments.

A heat dissipation substrate according to the present invention includes the above-described plastically-worked copper alloy material.

Since the heat dissipation substrate having the above-described configuration is manufactured by using the above-described plastically-worked copper alloy material, the heat dissipation substrate can exhibit excellent properties even in large current applications and high temperature environments.

[Advantageous Effects of Invention]

According to the present invention, it is possible to provide a copper alloy, a plastically-worked copper alloy material, a component for electronic and electrical devices, a terminal, a bus bar, a lead frame, and a heat dissipation substrate, which have a high electrical conductivity and excellent heat resistance.

[Brief Description of Drawings]

FIG. 1 is an explanatory cross sectional view of a copper alloy (plastically-worked copper alloy material) according to the present embodiment.

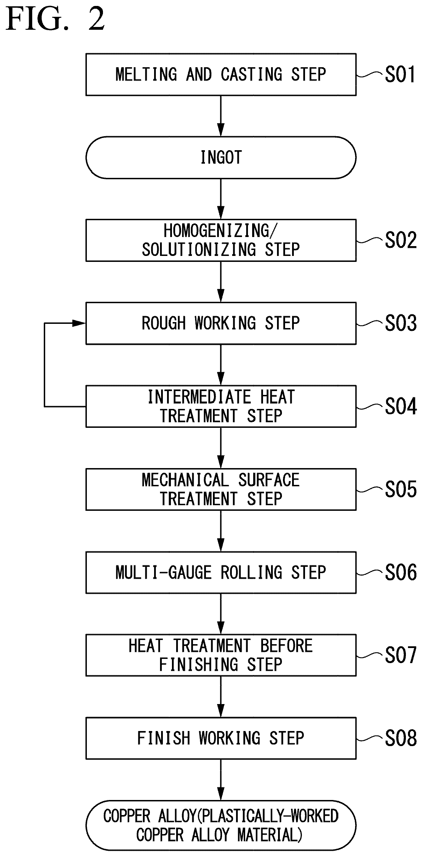

FIG. 2 is a flowchart showing a method for manufacturing the copper alloy according to the present embodiment.

[Description of Embodiments]

Hereinafter, a copper alloy according to an embodiment of the present invention will be described with reference to the drawings.

The copper alloy according to the present embodiment is optimally used as a material for a component for electronic and electrical devices such as a terminal, a bus bar, a lead frame, or a heat dissipation substrate.

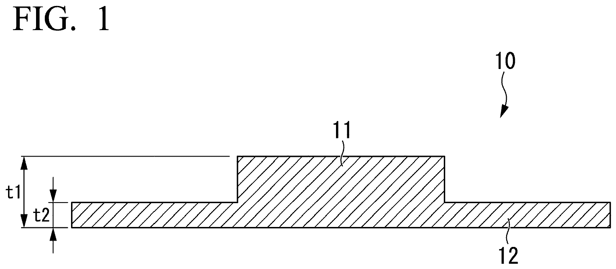

In addition, a plastically-worked copper alloy material according to the present embodiment includes the copper alloy according to the present embodiment. As shown in FIG. 1, a plastically-worked copper alloy material 10 according to the present embodiment is a multi-gauge strip including a thick portion 11 and a thin portion 12 having different thicknesses in a cross section orthogonal to a longitudinal direction.

The copper alloy according to the present embodiment has a composition including Mg in an amount of greater than 10 mass ppm and 100 mass ppm or less with the balance being Cu and inevitable impurities, in which in the inevitable impurities, the amount of S is 10 mass ppm or less, the amount of P is 10 mass ppm or less, the amount of Se is 5 mass ppm or less, the amount of Te is 5 mass ppm or less, the amount of Sb is 5 mass ppm or less, the amount of Bi is 5 mass ppm or less, the amount of As is 5 mass ppm or less, and a total amount of S, P, Se, Te, Sb, Bi, and As is 30 mass ppm or less.

Further, when the amount of Mg is indicated as [Mg] and the total amount of S, P, Se, Te, Sb, Bi, and As is indicated as [S + P + Se + Te + Sb + Bi + As], the mass ratio thereof [Mg]/[S + P + Se + Te + Sb + Bi + As] is in a range of 0.6 or greater and 50 or less.

Further, in the copper alloy according to the present embodiment, the amount of Ag may be 5 mass ppm or greater and 20 mass ppm or less.

Further, the copper alloy according to the present embodiment has an electrical conductivity of 97% IACS or greater.

Furthermore, in the copper alloy according to the present embodiment, the heatproof temperature is preferably 260°C or higher.

In addition, in the copper alloy according to the present embodiment, when a crystal orientation distribution function obtained from texture analysis by an EBSD method is expressed in terms of Euler angles, the average value of orientation densities at $\varphi2 = 0°$, in a range of $\varphi1 = 0°$ to $20°$, and in a range of $\Phi = 35°$ to $55°$ is 1.3 or greater and less than 20.0.

Furthermore, in the copper alloy according to the present embodiment, the area ratio of crystals having a crystal orientation of 10° or less with respect to an S orientation {123}<634> is set to be 10% or less.

With regard to the copper alloy according to the present embodiment, the reasons for specifying the component composition, various properties, and the crystal structure as described above will be explained below.

(Mg)

Mg is an element having an effect of improving a heatproof temperature without significantly decreasing the electrical conductivity by forming solid solutions of Mg in the matrix of copper.

In a case where the amount of Mg is 10 mass ppm or less, there is a concern that the effect may not be sufficiently exhibited. Meanwhile, in a case where the amount of Mg is greater than 100 mass ppm, the electrical conductivity may be decreased.

For these reasons, in the present embodiment, the amount of Mg is set to be in a range of greater than 10 mass ppm and 100 mass ppm or less.

In order to further improve the heatproof temperature, the lower limit of the amount of Mg is set to be preferably 20 mass ppm or greater, more preferably 30 mass ppm or greater, and still more preferably 40 mass ppm or greater.

In addition, in order to further increase the electrical conductivity, the upper limit of the amount of Mg is set to be preferably 90 mass ppm or less, more preferably 80 mass ppm or less, and still more preferably 70 mass ppm or less.

(S, P, Se, Te, Sb, Bi, and As)

The elements such as S, P, Se, Te, Sb, Bi, and As described above are elements that are likely to be generally mixed in a copper alloy. These elements are likely to react with Mg and form a compound, and thus may reduce the solid solution effect of Mg added in a small amount. Therefore, the amounts of these elements are required to be strictly controlled.

Therefore, in the present embodiment, it is preferable that the amount of S be limited to 10 mass ppm or less, the amount of P be limited to 10 mass ppm or less, the amount of Se be limited to 5 mass ppm or less, the amount of Te be limited to 5 mass ppm or less, the amount of Sb be limited to 5 mass ppm or less, the amount of Bi be limited to 5 mass ppm or less, and the amount of As be limited to 5 mass ppm or less.

Furthermore, the total amount of S, P, Se, Te, Sb, Bi, and As is limited to 30 mass ppm or less.

Further, the amount of S is preferably 9 mass ppm or less, and more preferably 8 mass ppm or less.

The amount of P is preferably 6 mass ppm or less, and more preferably 3 mass ppm or less.

The amount of Se is preferably 4 mass ppm or less, and more preferably 2 mass ppm or less.

The amount of Te is preferably 4 mass ppm or less, and more preferably 2 mass ppm or less.

The amount of Sb is preferably 4 mass ppm or less, and more preferably 2 mass ppm or less.

The amount of Bi is preferably 4 mass ppm or less, and more preferably 2 mass ppm or less.

The amount of As is preferably 4 mass ppm or less, and more preferably 2 mass ppm or less.

Furthermore, the total amount of S, P, Se, Te, Sb, Bi, and As is preferably 24 mass ppm or less, and more preferably 18 mass ppm or less.

$$([Mg]/[S + P + Se + Te + Sb + Bi + As])$$

As described above, since elements such as S, P, Se, Te, Sb, Bi, and As are likely to react with Mg and form a compound, the form of presence of Mg is controlled by defining the ratio between the amount of Mg and the total amount of S, P, Se, Te, Sb, Bi, and As in the present embodiment.

The amount of Mg is indicated as [Mg] and the total amount of S, P, Se, Te, Sb, Bi, and As is indicated as [S + P + Se + Te + Sb + Bi + As]. In a case where a mass ratio thereof [Mg]/[S + P + Se + Te + Sb + Bi + As] is greater than 50, Mg is excessively present in copper in a solid solution state, and thus the electrical conductivity may be decreased. Meanwhile, in a case where the mass ratio [Mg]/[S + P + Se + Te + Sb + Bi + As] is less than 0.6, Mg does not sufficiently form solid solutions of Mg, and thus the heatproof temperature may not be sufficiently improved.

Therefore, in the present embodiment, the mass ratio [Mg]/[S + P + Se + Te + Sb + Bi + As] is set to be in a range of 0.6 or greater and 50 or less.

In order to further increase the electrical conductivity, the upper limit of the mass ratio [Mg]/[S + P + Se + Te + Sb + Bi + As] is set to be preferably 35 or less, and more preferably 25 or less.

Further, in order to further improve the heat resistance, the lower limit of the mass ratio [Mg]/[S + P + Se + Te + Sb + Bi + As] is set to be preferably 0.8 or greater, and more preferably 1.0 or greater.

(Ag: 5 mass ppm or greater and 20 mass ppm or less)

Ag is unlikely to form solid solutions in the matrix of Cu in a normal temperature range of 250°C or lower in which electronic and electrical devices are used. Therefore, Ag added in a small amount to copper segregates in the vicinity of grain boundaries. In this manner, since the movement of atoms at grain boundaries is disturbed and grain boundary diffusion is suppressed, the heat resistance is improved.

In a case where the amount of Ag is 5 mass ppm or greater, the effect can be sufficiently exhibited. Meanwhile, in a case where the amount of Ag is 20 mass ppm or less, the electrical conductivity can be ensured and an increase in the manufacturing cost can be suppressed.

For these reasons, in the present embodiment, the amount of Ag is set to be in a range of 5 mass ppm or greater and 20 mass ppm or less.

In order to further improve the heat resistance, the lower limit of the amount of Ag is set to be preferably 6 mass ppm or greater, more preferably 7 mass ppm or greater, and still more preferably 8 mass ppm or greater. In addition, in order to reliably suppress a decrease in the electrical conductivity and an increase in the cost, the upper limit of the amount of Ag is set to be preferably 18 mass ppm or less, more preferably 16 mass ppm or less, and still more preferably 14 mass ppm or less.

Further, in a case where Ag is not intentionally added, the amount of Ag may be less than 5 mass ppm.

(Other Inevitable Impurities)

Examples of inevitable impurities other than the above-described elements include Al, B, Ba, Be, Ca, Cd, Cr, Sc, rare earth elements, V, Nb, Ta, Mo, Ni, W, Mn, Re, Ru, Sr, Ti, Os, Co, Rh, Ir, Pb, Pd, Pt, Au, Zn, Zr, Hf, Hg, Ga, In, Ge, Y, Tl, N, Si, Sn, and Li. These inevitable impurities may be contained within a range not to affect the properties.

Since there is a concern that these inevitable impurities may decrease the electrical conductivity, the total amount of the inevitable impurities is set to be preferably 0.1 mass% or less, more preferably 0.05 mass% or less, still more preferably 0.03 mass% or less, and far still more preferably 0.01 mass% or less.

In addition, the upper limit of the amount of each of the inevitable impurities is set to be preferably 10 mass ppm or less, more preferably 5 mass ppm or less, and still more preferably 2 mass ppm or less.

(Average Value of Orientation Densities at $\varphi 2 = 0°$, in Range of $\varphi 1 = 0°$ to $20°$, and in Range of $\Phi = 35°$ to $55°$)

The Euler angles represent the crystal orientation based on the relationship between the specimen coordinate system and the crystal axes of individual crystal grains, and the crystal orientation is expressed by rotating ($\varphi 1$, $\Phi$, $\varphi 2$) around the (Z-X-Z) axis from a state where crystal axes (X-Y-Z) match each other. By displaying a crystal orientation distribution function (ODF) in a three-dimensional Euler space by a series expansion method, it is possible to confirm the crystal orientation density distribution in the measurement range. The orientation density distribution defines a completely random orientation state obtained from a standard powder specimen or the like as 1, and for example, in a case where the orientation density in a certain orientation is 3, this means that the orientation density in this certain orientation is three times more present than random orientation.

The crystal orientation at $\varphi 2 = 0°$, in a range of $\varphi 1 = 0°$ to $20°$, and in a range of $\Phi = 35°$ to $55°$ when represented by the Euler angles ($\varphi 1$, $\Phi$, $\varphi 2$) is the recrystallized structure formed by a specific combination of a heat treatment and working, in which strain tends to be less likely to be localized than in cases of other crystal orientations. Therefore, in a case where the orientation density at $\varphi 2 = 0°$, in a range of $\varphi 1 = 0°$ to $20°$, and in a range of $\Phi = 35°$ to $55°$ when represented by the Euler angles ($\varphi 1$, $\Phi$, $\varphi 2$) increases, recovery or recrystallization by the movement of dislocations is unlikely to occur, and the heat resistance of a copper material is improved.

Accordingly, in a case where the average value of the orientation densities described above is 1.3 or greater, sufficiently high heat resistance can be obtained. Meanwhile, in a case where the average value of the orientation densities described above is less than 20.0, it is possible to obtain a constant strength while maintaining the heat resistance, and the handling during manufacturing is improved.

For these reasons, in the present embodiment, the average value of the orientation densities at $\varphi 2 = 0°$, in a range of $\varphi 1 = 0°$ to $20°$, and in a range of $\Phi = 35°$ to $55°$ is set to be in a range of 1.3 or greater and less than 20.0.

The lower limit of the average value of the orientation densities described above is set to be preferably 1.6 or greater, more preferably 2.0 or greater, still more preferably 2.5 or greater, and far still more preferably 3.0 or greater. Meanwhile, the upper limit of the average value of the orientation densities described above is more preferably 18 or less, and still more preferably 15 or less.

In a case where a thick portion and a thin portion are present and they have different material structures similar to those in a multi-gauge strip, the average value of the orientation densities at $\varphi2 = 0°$, in a range of $\varphi1 = 0°$ to $20°$, and in a range of $\Phi = 35°$ to $55°$ when represented by the Euler angles ($\varphi1$, $\Phi$, $\varphi2$) is in the above-described range in both the thick portion and the thin portion.

(Proportion of Crystals Having Crystal Orientation of 10° or less with respect to S Orientation { 123}<634>)

The S orientation {123 } <634> is a representative rolled texture of copper, but strain is more likely to be localized in the S orientation {123 }<634> than in other orientations. Accordingly, recovery by the movement of dislocations is likely to occur with an increase in the proportion of the S orientation, and the heat resistance of the copper material deteriorates.
Therefore, in the present embodiment, the area ratio of crystals having a crystal orientation of 10° or less with respect to the S orientation {123 }<634> is set to be 10% or less.
The area ratio of crystals having a crystal orientation of 10° or less with respect to the S orientation {123}<634> is preferably 8% or less, more preferably 6% or less, and still more preferably 4% or less.
In addition, the lower limit thereof is not particularly limited, but generally 0.1% or greater in a case where the shape is formed by rolling.
In a case where a thick portion and a thin portion are present and they have different material structures similar to those in a multi-gauge strip, the area ratio of crystals having a crystal orientation of 10° or less with respect to the S orientation { 123}<634> is in the above-described range in both the thick portion and the thin portion.

(Electrical Conductivity)

In the copper alloy according to the present embodiment, the electrical conductivity is 97.0% IACS or greater. The heat generation during energization is suppressed by setting the electrical conductivity to be 97.0% IACS or greater so that the copper alloy can be satisfactorily used as a component for electronic and electrical devices such as a terminal, a bus bar, a lead frame, or a heat dissipation member as a substitute to a pure copper material.
The electrical conductivity is preferably 97.5% IACS or greater, more preferably 98.0% IACS or greater, still more preferably 98.5% IACS or greater, and far still more preferably 99.0% IACS or greater.
Although not particularly limited, the electrical conductivity may be 101.5% IACS or less, 101.0% IACS or less, or 99.6% IACS or less.
In a case where a thick portion and a thin portion are present and they have different material structures similar to those in a multi-gauge strip, the electrical conductivity is in the above-described range in both the thick portion and the thin portion.

(Heatproof Temperature)

In the copper alloy according to the present embodiment, in a case where the heatproof temperature is high, the copper alloy is more suitable for use in high temperature environments.
Therefore, in the copper alloy according to the present embodiment, the heatproof temperature is preferably 260°C or higher.
The heatproof temperature is more preferably 280°C or higher, still more preferably 300°C or higher, and far still more preferably 320°C or higher.
In a case where a thick portion and a thin portion are present and they have different material structures similar to those in a multi-gauge strip, the heatproof temperature is in the above-described range in both the thick portion and the thin portion.
Next, a method for manufacturing the copper alloy according to the present embodiment with such a configuration will be described with reference to the flowchart shown in FIG. 1.

(Melting and Casting Step S01)

First, a copper raw material is melted to obtain a molten copper, and the above-described elements are added to the molten copper to adjust components, and thus a molten copper alloy is produced. Further, a single element, a mother alloy, or the like can be used for addition of various elements. In addition, raw materials containing the above-described elements may be melted together with the copper raw material. Further, a recycled material or a scrap material of the alloy of the present embodiment may be used.
As the copper raw material, so-called 4N Cu having a purity of 99.99 mass% or greater or so-called 5N Cu having a purity of 99.999 mass% or greater is preferably used.

In order to suppress the oxidation of Mg and in order to reduce the hydrogen concentration during melting, it is preferable that the melting be carried out in an inert gas atmosphere (for example, Ar gas) in which the vapor pressure of $H_2O$ is low and the holding time for the melting be set to the minimum.

The molten copper alloy in which the components have been adjusted is poured into a mold to produce an ingot. In consideration of mass production, a continuous casting method or a semi-continuous casting method is preferably used.

(Homogenizing/Solutionizing Step S02)

Next, a heating treatment is performed for homogenization and solutionization of the obtained ingot. Intermetallic compounds or the like containing Cu and Mg as main components may be present inside the ingot, which are generated by segregation and concentration of Mg in the course of solidification. Therefore, in order to eliminate or reduce the segregation, intermetallic compounds, and the like, a heating treatment is performed by heating the ingot at a temperature of 300°C or higher and 1080°C or lower; and thereby, Mg is diffused homogeneously or solid solutions of Mg are formed in the matrix in the ingot. In addition, the homogenizing/solutionizing step S02 is preferably performed in a non-oxidizing or reducing atmosphere.

In a case where the heating temperature is lower than 300°C, the solutionization may be incomplete, and a large amount of the intermetallic compounds containing Cu and Mg as main components may remain in the matrix. Meanwhile, in a case where the heating temperature is higher than 1080°C, a part of the copper material may turn into a liquid phase, and the structure and surface state may be non-uniform. Therefore, the heating temperature is set to be in a range of 300°C or higher and 1080°C or lower.

Hot working may be performed after the above-described homogenizing/solutionizing step S02, in order to improve the efficiency of rough rolling to be described below and to homogenize the structure. In this case, the working method is not particularly limited, and for example, rolling, drawing, extruding, groove rolling, forging, and pressing can be employed. Further, the hot working temperature is preferably set to be in a range of 300°C or higher and 1080°C or lower.

(Rough Working Step S03)

In order to work the ingot into a predetermined shape, rough working is performed. Further, the temperature conditions for the rough working step S03 are not particularly limited, but in order to suppress the recrystallization or improve the dimensional accuracy, the working temperature is preferably set to be in a range of -200°C to 200°C in which cold rolling or warm rolling is carried out, and particularly preferably room temperature. The working ratio is preferably 20% or greater, and more preferably 30% or greater. Furthermore, the working method is not particularly limited, and for example, rolling, drawing, extruding, groove rolling, forging, and pressing can be employed.

The rough working step S03 and an intermediate heat treatment step S04 to be described below may be repeated.

(Intermediate Heat Treatment Step S04)

After the rough working step S03, a heat treatment is performed to soften the ingot for workability improvement or to form a recrystallized structure.

In this case, a heat treatment in a continuous annealing furnace for a short period of time is preferable, and localization of Ag segregation to grain boundaries can be prevented in a case where Ag is added.

The heat treatment conditions are not particularly limited, but the heat treatment is generally performed in a range of 200°C to 1000°C.

(Mechanical Surface Treatment Step S05)

After the intermediate heat treatment step S04, a mechanical surface treatment is performed. The mechanical surface treatment is a treatment that applies a compressive stress to the vicinity of the surface. In a case where the mechanical surface treatment is combined with a heat treatment before finishing step S07 to be described below, the orientation density at $\varphi 2 = 0°$, in a range of $\varphi 1 = 0°$ to 20°, and in a range of $\Phi = 35°$ to 55° when represented by the Euler angles ($\varphi 1$, $\Phi$, $\varphi 2$) increases and the S orientation decreases, so that the heat resistance can be improved.

As the mechanical surface treatment, it is possible to use various methods that have been generally used, such as a shot peening treatment, a blast treatment, a lapping treatment, a polishing treatment, buff polishing, grinder polishing, sandpaper polishing, a tension leveler treatment, and light rolling with a low rolling reduction per pass (the rolling reduction per pass is set to be 1% to 10%, and the rolling is repeatedly performed three or more times).

(Multi-Gauge Rolling Step S06)

Multi-gauge rolling step S06 may be performed in a case where a multi-gauge cross-section copper alloy sheet is desired in which a thick portion and a thin portion are arranged in a width direction.

In the multi-gauge rolling, the material subjected to the mechanical surface treatment step S05 is subjected to cold multi-gauge rolling by a flat plate-shaped die having an uneven surface and a rolling roll facing a forming surface of the die and reciprocally moving along the forming surface, and thus a rough multi-gauge cross-section copper alloy sheet having a rough thick portion and a rough thin portion arranged in a width direction is obtained.

Through the working in the multi-gauge rolling step S06 and the heat treatment before finishing step S07 to be described below, the orientation density at $\varphi2 = 0°$, in a range of $\varphi1 = 0°$ to $20°$, and in a range of $\Phi = 35°$ to $55°$ when represented by the Euler angles ($\varphi1$, $\Phi$, $\varphi2$) increases, but the S orientation also tends to increase. Therefore, the working ratio is preferably set to be in a range of 5% or greater and 90% or less. In addition, in order to minimize differences in the material structure between the thick portion and the thin portion and the consequent heat resistance, the ratio of the thickness of the thick portion to the thickness of the thin portion is preferably set to be in a range of 1.1 or greater and 8.0 or less in the multi-gauge rolling step S06.

(Heat Treatment Before Finishing Step S07)

Next, a heat treatment is performed. In particular, in a case where the multi-gauge rolling step S06 is performed, due to the multi-gauge rolling step S06 and the recrystallization in the heat treatment before finishing step S07, the orientation density at $\varphi2 = 0°$, in a range of $\varphi1 = 0°$ to $20°$, and in a range of $\Phi = 35°$ to $55°$ when represented by the Euler angles ($\varphi1$, $\Phi$, $\varphi2$) increases and the S orientation decreases.

The heat treatment temperature in the heat treatment before finishing step S07 is preferably in a range of 250°C or higher and 650°C or lower and the holding time at the heat treatment temperature is preferably in a range of 0.1 hours or longer and 100 hours or shorter. For example, in a case where the heat treatment temperature is 400°C, the holding time is preferably set to be 10 hours.

(Finish Working Step S08)

After the heat treatment before finishing step S07, a finish working step S08 is performed to adjust the strength. In a case where the finish working step S08 is not performed, the recrystallized structure remains as it is, and thus the strength is significantly low and the handling becomes difficult.

In a case where a multi-gauge strip having a thick portion and a thin portion is formed by the multi-gauge rolling step S06, cold working is preferably performed by rolling rolls including a stepped roll and a flat roll.

Since a rolled texture is formed by the finish working step S08, the orientation density at $\varphi2 = 0°$, in a range of $\varphi1 = 0°$ to $20°$, and in a range of $\Phi = 35°$ to $55°$ when represented by the Euler angles ($\varphi1$, $\Phi$, $\varphi2$) decreases and the S orientation also increases when the working ratio is too high.

Therefore, the working ratio in the finish working step S08 is set to be preferably 50% or less, and more preferably 45% or less. In addition, the working ratio is set to be preferably 5% or greater, and more preferably 8% or greater.

Further, low-temperature annealing may be performed after the finish working step S08. In addition, a correction step using a tension leveler or the like may be added.

In this manner, the copper alloy (plastically-worked copper alloy material) according to the present embodiment is produced. Further, the plastically-worked copper alloy material produced by rolling is referred to as a copper alloy rolled sheet.

As shown in FIG. 1, the copper alloy (plastically-worked copper alloy material) 10 according to the present embodiment has the thick portion 11 and the thin portion 12 having different thicknesses in a cross section orthogonal to the longitudinal direction, and it is preferable that a thickness $t1$ of the thick portion 11 be in a range of 0.2 mm or greater and 10 mm or less and a thickness $t2$ of the thin portion 12 be in a range of 0.1 mm or greater and 5.0 mm or less.

In addition, a ratio $t1/t2$ of the thickness $t1$ of the thick portion 11 to the thickness $t2$ of the thin portion 12 is preferably in a range of 1.1 or greater and 8.0 or less.

In a case where the multi-gauge rolling step S06 is not performed, the thickness of the copper alloy (plastically-worked copper alloy material) 10 is preferably in a range of 0.1 mm or greater and 10 mm or less.

In the copper alloy according to the present embodiment having the above-described configuration, since the amount of Mg is set to be in a range of greater than 10 mass ppm and 100 mass ppm or less, the amount of S is set to be 10 mass ppm or less, the amount of P is set to be 10 mass ppm or less, the amount of Se is set to be 5 mass ppm or less, the amount of Te is set to be 5 mass ppm or less, the amount of Sb is set to be 5 mass ppm or less, the amount of Bi is set to be 5 mass ppm or less, the amount of As is set to be 5 mass ppm or less, and the total amount of S, P, Se, Te, Sb, Bi, and As, that are the elements generating compounds with Mg, is limited to 30 mass ppm or less, Mg added in a small amount can form solid solutions of Mg in the matrix of copper, and the heatproof temperature can thus be improved without a significant decrease in the electrical conductivity.

Further, when the amount of Mg is indicated as [Mg] and the total amount of S, P, Se, Te, Sb, Bi, and As is indicated as [S + P + Se + Te + Sb + Bi + As], the mass ratio thereof [Mg]/[S + P + Se + Te + Sb + Bi + As] is set to be in a range of 0.6 or greater and 50 or less, and thus the heatproof temperature can be sufficiently improved without a decrease in the electrical conductivity due to the excessive formation of solid solutions of Mg.

Accordingly, according to the copper alloy of the present embodiment, it is possible to achieve both a high electrical conductivity and excellent heat resistance. Specifically, the electrical conductivity can be set to be 97% IACS or greater, and a high electrical conductivity can be ensured.

Furthermore, in the copper alloy according to the present embodiment, in a case where the amount of Ag is set to be in a range of 5 mass ppm or greater and 20 mass ppm or less, Ag segregates in the vicinity of grain boundaries and grain boundary diffusion is suppressed by Ag, so that the heatproof temperature can be further reliably improved.

Further, in a case where the heatproof temperature of the copper alloy according to the present embodiment is 260°C or higher, the copper alloy has sufficiently excellent heat resistance, and thus can be used stably even in high temperature environments.

Since the plastically-worked copper alloy material according to the present embodiment includes the above-described copper alloy, the plastically-worked copper alloy material has excellent conductive properties and heat resistance, and is particularly suitable as a material for a component for electronic and electrical devices, such as a terminal, a bus bar, a lead frame, or a heat dissipation substrate.

In addition, since the plastically-worked copper alloy material according to the present embodiment is a multi-gauge strip including a thin portion and a thick portion having different sheet thicknesses in a cross section orthogonal to the longitudinal direction, a component for electronic and electrical devices having excellent properties can be obtained by applying the thin portion and the thick portion to the parts of the component for electronic and electrical devices.

Furthermore, in a case where a metal plating layer is formed on the surface of the plastically-worked copper alloy material according to the present embodiment, various properties can be imparted to the surface, and the plastically-worked copper alloy material is particularly suitable as a material for a component for electronic and electrical devices, such as a terminal, a bus bar, or a heat dissipation member.

Furthermore, since the component for electronic and electrical devices (such as a terminal, a bus bar, a lead frame, or a heat dissipation member) according to the present embodiment includes the above-described plastically-worked copper alloy material, the component for electronic and electrical devices can exhibit excellent properties even in large current applications and high temperature environments.

The copper alloy, the plastically-worked copper alloy material, and the component for electronic and electrical devices (such as a terminal, a bus bar, or a lead frame) according to the embodiment of the present invention have been described as above, but the present invention is not limited thereto and can be appropriately changed within a range not departing from the technical features of the invention.

For example, in the above-described embodiment, an example of the method for manufacturing the copper alloy (plastically-worked copper alloy material) has been described, but the method for manufacturing the copper alloy is not limited to the description of the embodiment, and the copper alloy may be manufactured by appropriately selecting a manufacturing method of the related art.

In addition, in the present embodiment, the multi-gauge strip having the shape shown in FIG. 1 has been described as an example. However, the present invention is not limited thereto, and a multi-gauge strip having another cross section shape or a strip having a constant sheet thickness may be used. In addition, a wire material, a rod, or the like may be used.

[Examples]

Hereinafter, results of confirmation experiments performed to confirm the effects of the present invention will be described.

A raw material which consisted of pure copper having a purity of 99.999 mass% or greater was obtained by a zone melting refining method, and the raw material was put into a high purity graphite crucible and melted by a high frequency induction heating in an Ar gas atmosphere furnace.

Various 0.1 mass% mother alloys were produced by using high purity copper of 6N (purity: 99.9999 mass%) or higher and pure metals having a purity of 2N (purity: 99 mass%) or higher, and component compositions shown in Tables 1 and 2 were prepared by adding the mother alloys in the obtained molten copper. The resulting materials were poured into a heat insulating material (isowool) casting mold, and thus ingots were produced. The ingots had a size of about 30 mm in thickness x about 60 mm in width x about 150 to 200 mm in length.

The obtained ingots were heated for 1 hour in an Ar gas atmosphere under various temperature conditions, the ingots were subjected to surface grinding to remove an oxide film, and the ingots were cut into a predetermined size.

Thereafter, the thickness was appropriately adjusted to be a final thickness, and the ingots were cut. Each of the cut specimens was subjected to rough rolling at room temperature at a working ratio shown in Tables 3 and 4, and then subjected to an intermediate heat treatment under the heat treatment conditions listed in Tables 3 and 4.

Next, these specimens were subjected to a mechanical surface treatment step by the methods listed in Tables 3 and 4.

Buff polishing was performed using #1000 abrasive paper.

A tension leveler treatment was performed using a tension leveler provided with a plurality of $\varphi$16 mm rolls, and the line tension was set to 100 N/mm$^2$.

Light rolling (rolling with a low rolling reduction per pass) was performed with a rolling reduction of 4% per pass for the final 3 passes.

Then, except for some specimens, the specimens were subjected to a stepped multi-gauge working by a flat plate-shaped die and a rolling roll facing a forming surface of the die and reciprocally moving along the forming surface, so that thicknesses of a thick portion and a thin portions were values listed in Tables 3 and 4.

Then, except for some specimens, the specimens were subjected to a heat treatment before finishing under the conditions listed in Tables 3 and 4.

Thereafter, finish working was performed under the conditions listed in Tables 3 and 4 to produce strips for property evaluation having a width of about 60 mm and a thickness shown in Tables 5 and 6.

The obtained strips for property evaluation were evaluated as follows.

(Composition Analysis)

A measurement specimen was collected from the obtained ingot. The amount of Mg was measured by inductively coupled plasma optical emission spectrometry, and the amounts of other elements were measured using a glow discharge mass spectrometer (GD-MS).

The measurement was performed at two sites, a central portion of the specimen and an end portion of the specimen in the width direction, and the larger amount was defined as the amount of the sample. As a result, it was confirmed that the component compositions were as shown in Tables 1 and 2.

(Electrical Conductivity)

A test piece of 10 mm in width x 60 mm in length was collected from the strip for property evaluation, and the electric resistance was obtained by a 4-terminal method. In addition, dimensions of the test piece were measured using a micrometer, and the volume of the test piece was calculated. Then, the electrical conductivity was calculated from the measured electric resistance value and the volume. The test piece was collected so that the longitudinal direction thereof was parallel to the rolling direction of the strip for property evaluation. The evaluation results are shown in Tables 5 and 6.

(Crystal Orientation)

The obtained strip for property evaluation was cut into a size of 20 mm in width x 20 mm in length, and a surface perpendicular to the width direction of rolling, that is, a transverse direction (TD) surface was used as an observation surface and embedded in a resin. Mechanical polishing was performed thereon using waterproof abrasive paper and diamond abrasive grains, and then finish polishing was performed using a colloidal silica solution to obtain a sample for observation.

Thereafter, individual measurement points (pixels) in a measurement range of a specimen surface were irradiated with electron beams using an electron scanning microscope, and a pattern was obtained by back-scattered electron beam diffraction to measure, by an SEM-EBSD (electron backscatter diffraction patterns) measurement device, an orientation density at $\varphi2 = 0°$, in a range of $\varphi1 = 0°$ to 20°, and in a range of $\Phi = 35°$ to 55° when represented by the Euler angles ($\varphi1$, $\Phi$, $\varphi2$) and a proportion of an S orientation as follows.

A boundary between adjacent measurement points where the orientation difference between the measurement points was 15° or greater was defined as a high angle grain boundary. Twin boundaries were also defined as high angle grain boundaries. Further, the measurement range was adjusted to contain 100 or more crystal grains in each sample. A crystal grain boundary map was created using the high angle grain boundaries based on the obtained orientation analysis results. In conformity with the cutting method of JIS H 0501, five vertical line segments and five horizontal line segments having a predetermined length were drawn on the crystal grain boundary map, the number of crystal grains that were completely cut was counted, and an average value, that is, an average crystal grain size was obtained by dividing the total cut length (lengths of the line segments cut off at the crystal grain boundaries) by the number of crystal grains.

Next, the observation surface was measured by the EBSD method at every measurement interval that was 1/10 or less of the obtained average crystal grain size. The measurement results were analyzed by data analysis software OIM in a measurement area where the total area was 10000 $\mu m^2$ or greater in a plurality of visual fields so that a total of 1000 or more crystal grains were included, to obtain a confidence index (CI) value at each measurement point. The structure was analyzed by the data analysis software OIM at the measurement points excluding the measurement points where the CI value was 0.1 or less to obtain the proportion of the S orientation and the crystal orientation distribution function.

The crystal orientation distribution function obtained by the analysis was expressed in terms of Euler angles. The proportion of the S orientation and the average value of the orientation densities at $\varphi 2 = 0°$, in a range of $\varphi 1 = 0°$ to 20°, and in a range of $\Phi = 35°$ to 55° that have been obtained are shown in Tables 5 and 6. In Tables 5 and 6, the average value of the orientation densities at $\varphi 2 = 0°$, in a range of $\varphi 1 = 0°$ to 20°, and in a range of $\Phi = 35°$ to 55° are listed in the column of "ODF".

(Heatproof Temperature)

To evaluate a heatproof temperature, an isochronal annealing curve was acquired based on the Vickers hardness after one hour of a heat treatment in conformity with JCBA T325: 2013 of Japan Copper and Brass Association, and a heating temperature at which the hardness decreased to 80% of the hardness before the heat treatment was obtained. A rolled surface was used as a measurement surface for the Vickers hardness. The evaluation results are shown in Tables 5 and 6.

[Table 1]

| | | Component Composition (Mass Ratio) | | | | | | | | | | [S + P + Se + Te + Sb + Bi + As] ppm | [Mg]/ [S + P + Se + Te + Sb + Bi + As] |
|---|---|---|---|---|---|---|---|---|---|---|---|---|---|
| | | Mg ppm | Ag ppm | Impurities | | | | | | | Cu | | |
| | | | | S ppm | P ppm | Se ppm | Te ppm | Sb ppm | Bi ppm | As ppm | | | |
| Invention Examples | 1 | 11 | 14.0 | 3.0 | 2.0 | 2.0 | 2.0 | 2.0 | 2.0 | 2.0 | Balance | 15.0 | 0.7 |
| | 2 | 22 | 10.0 | 8.0 | 3.0 | 2.0 | 3.0 | 3.0 | 3.0 | 2.0 | Balance | 24.0 | 0.9 |
| | 3 | 31 | 8.0 | 7.0 | 3.0 | 2.0 | 2.0 | 2.0 | 1.0 | 1.0 | Balance | 18.0 | 1.7 |
| | 4 | 42 | 11.0 | 4.0 | 1.0 | 2.0 | 2.0 | 1.0 | 0.0 | 0.0 | Balance | 10.0 | 4.2 |
| | 5 | 99 | 9.0 | 7.0 | 1.0 | 1.0 | 2.0 | 0.0 | 2.0 | 2.0 | Balance | 15.0 | 6.6 |
| | 6 | 82 | 12.0 | 4.0 | 1.0 | 2.0 | 1.0 | 2.0 | 2.0 | 0.0 | Balance | 12.0 | 6.8 |
| | 7 | 71 | 12.0 | 4.0 | 3.0 | 0.0 | 0.0 | 2.0 | 1.0 | 1.0 | Balance | 11.0 | 6.5 |
| | 8 | 60 | 9.0 | 7.0 | 1.0 | 2.0 | 0.0 | 2.0 | 1.0 | 1.0 | Balance | 14.0 | 4.3 |
| | 9 | 67 | 17.0 | 10.0 | 1.0 | 0.0 | 3.0 | 2.0 | 0.0 | 0.0 | Balance | 16.0 | 4.2 |
| | 10 | 63 | 0.0 | 3.0 | 9.0 | 0.0 | 1.0 | 0.0 | 0.0 | 3.0 | Balance | 16.0 | 3.9 |
| | 11 | 58 | 8.0 | 5.0 | 0.0 | 5.0 | 0.0 | 0.0 | 3.0 | 1.0 | Balance | 14.0 | 4.1 |
| | 12 | 41 | 6.0 | 7.0 | 2.0 | 1.0 | 4.0 | 1.0 | 0.0 | 2.0 | Balance | 17.0 | 2.4 |
| | 13 | 69 | 15.0 | 3.0 | 4.0 | 2.0 | 2.0 | 5.0 | 1.0 | 0.0 | Balance | 17.0 | 4.1 |
| | 14 | 46 | 7.0 | 4.0 | 1.0 | 3.0 | 1.0 | 0.0 | 5.0 | 0.0 | Balance | 14.0 | 3.3 |
| | 15 | 43 | 10.0 | 9.0 | 1.0 | 1.0 | 0.0 | 0.0 | 0.0 | 5.0 | Balance | 16.0 | 2.7 |
| | 16 | 49 | 19.0 | 8.0 | 0.0 | 0.0 | 2.0 | 3.0 | 0.0 | 1.0 | Balance | 14.0 | 3.5 |

[Table 2]

| | | Component Composition (Mass Ratio) | | | | | | | | | | [S + P + Se + Te + Sb + Bi + As] ppm | [Mg]/ [S + P + Se + Te + Sb + Bi + As] |
|---|---|---|---|---|---|---|---|---|---|---|---|---|---|
| | | Mg ppm | Ag ppm | Impurities | | | | | | | Cu | | |
| | | | | S ppm | P ppm | Se ppm | Te ppm | Sb ppm | Bi ppm | As ppm | | | |
| Invention Examples | 17 | 48 | 11.0 | 7.0 | 4.0 | 3.0 | 2.0 | 2.0 | 3.0 | 4.0 | Balance | 25.0 | 1.9 |
| | 18 | 56 | 9.0 | 3.0 | 5.0 | 4.0 | 3.0 | 1.0 | 2.0 | 3.0 | Balance | 21.0 | 2.7 |
| | 19 | 45 | 9.0 | 1.0 | 0.0 | 0.0 | 0.0 | 0.0 | 0.0 | 0.0 | Balance | 1.0 | 45.0 |
| | 20 | 59 | 10.0 | 2.0 | 0.0 | 0.0 | 0.0 | 0.0 | 0.0 | 0.0 | Balance | 2.0 | 29.5 |
| | 21 | 40 | 13.0 | 5.0 | 2.0 | 1.0 | 2.0 | 2.0 | 2.0 | 1.0 | Balance | 15.0 | 2.7 |
| | 22 | 65 | 12.0 | 5.0 | 1.0 | 1.0 | 1.0 | 2.0 | 2.0 | 1.0 | Balance | 13.0 | 5.0 |
| | 23 | 53 | 13.0 | 7.0 | 2.0 | 2.0 | 0.0 | 1.0 | 1.0 | 2.0 | Balance | 15.0 | 3.5 |
| | 24 | 55 | 10.0 | 4.0 | 0.0 | 0.0 | 0.0 | 0.0 | 0.0 | 0.0 | Balance | 4.0 | 13.8 |
| Comparative Examples | 1 | 5 | 12.0 | 3.0 | 0.0 | 1.0 | 0.0 | 0.0 | 1.0 | 0.0 | Balance | 5.0 | 1.0 |
| | 2 | 2300 | 10.0 | 3.0 | 1.0 | 2.0 | 1.0 | 0.0 | 1.0 | 0.0 | Balance | 8.0 | 287.5 |
| | 3 | 59 | 9.0 | 10.0 | 8.0 | 3.0 | 4.0 | 3.0 | 4.0 | 5.0 | Balance | 37.0 | 1.6 |
| | 4 | 12 | 14.0 | 9.0 | 9.0 | 3.0 | 2.0 | 1.0 | 2.0 | 3.0 | Balance | 29.0 | 0.4 |
| | 5 | 49 | 10.0 | 3.0 | 1.0 | 0.0 | 1.0 | 0.0 | 1.0 | 1.0 | Balance | 7.0 | 7.0 |
| | 6 | 64 | 11.0 | 7.0 | 0.0 | 0.0 | 0.0 | 2.0 | 1.0 | 2.0 | Balance | 12.0 | 5.3 |

[Table 3]

| | | Manufacturing Process | | | | | | | | | | |
|---|---|---|---|---|---|---|---|---|---|---|---|---|
| | | Rough Working | Intermediate Heat Treatment | | Mechanical Surface Treatment | Multi-Gauge Working | | | | Heat Treatment Before Finishing | | Finish Working |
| | | Rolling Ratio % | Temperature °C | Time hr | | Sheet Thickness (mm) | | Area Reduction Rate (%) | | Temperature °C | Time hr | Rolling Ratio % |
| | | | | | | Thin Portion | Thick Portion | Thin Portion | Thick Portion | | | |
| Invention Examples | 1 | 90 | 530 | 1 | Buff Polishing | 0.9 | 2.3 | 71 | 24 | 470 | 3 | 30 |
| | 2 | 92 | 300 | 80 | Tension Leveler | 0.8 | 0.9 | 66 | 60 | 280 | 95 | 24 |
| | 3 | 87 | 510 | 1 | Light Rolling | 2.5 | 3.6 | 38 | 9 | 540 | 1 | 20 |
| | 4 | 87 | 630 | 0.1 | Buff Polishing | 1.2 | 2.8 | 69 | 27 | 550 | 1 | 14 |
| | 5 | 89 | 410 | 10 | Tension Leveler | 1.5 | 2.6 | 57 | 23 | 380 | 20 | 5 |
| | 6 | 85 | 630 | 0.1 | Light Rolling | 1.0 | 3.0 | 78 | 32 | 450 | 5 | 7 |
| | 7 | 84 | 320 | 70 | Buff Polishing | 1.3 | 3.9 | 73 | 18 | 370 | 30 | 8 |
| | 8 | 83 | 630 | 0.1 | Tension Leveler | 2.6 | 4.7 | 47 | 6 | 570 | 1 | 13 |
| | 9 | 85 | 420 | 8 | Light Rolling | 2.6 | 4.0 | 42 | 12 | 320 | 70 | 27 |
| | 10 | 89 | 270 | 95 | Buff Polishing | 2.0 | 2.8 | 42 | 19 | 0 | 0 | 24 |
| | 11 | 89 | 250 | 100 | Tension Leveler | 1.0 | 2.4 | 68 | 25 | 450 | 5 | 21 |
| | 12 | 92 | 300 | 80 | Light Rolling | 2.4 | 2.4 | 0 | 0 | 620 | 0.1 | 15 |
| | 13 | 87 | 280 | 95 | Buff Polishing | 0.3 | 0.8 | 91 | 80 | 280 | 95 | 14 |
| | 14 | 94 | 370 | 30 | Tension Leveler | 0.8 | 1.0 | 57 | 45 | 420 | 8 | 14 |
| | 15 | 88 | 430 | 8 | Light Rolling | 2.4 | 3.1 | 35 | 15 | 360 | 40 | 15 |
| | 16 | 93 | 460 | 4 | Buff Polishing | 1.3 | 1.6 | 41 | 25 | 550 | 1 | 15 |

[Table 4]

| | | Manufacturing Process | | | | | | | | | | |
|---|---|---|---|---|---|---|---|---|---|---|---|---|
| | | Rough Working | Intermediate Heat Treatment | | Mechanical Surface Treatment | Multi-Gauge Working | | | | Heat Treatment Before Finishing | | Finish Working |
| | | Rolling Ratio % | Temperature °C | Time hr | | Sheet Thickness (mm) | | Area Reduction Rate (%) | | Temperature °C | Time hr | Rolling Ratio % |
| | | | | | | Thin Portion | Thick Portion | Thin Portion | Thick Portion | | | |
| Invention Examples | 17 | 86 | 280 | 95 | Tension Leveler | 3.1 | 3.7 | 24 | 10 | 310 | 75 | 13 |
| | 18 | 80 | 330 | 55 | Light Rolling | 3.9 | 5.4 | 35 | 10 | 400 | 10 | 7 |
| | 19 | 96 | 270 | 95 | Buff Polishing | 0.1 | 1.0 | 89 | 9 | 430 | 8 | 16 |
| | 20 | 90 | 540 | 1 | Tension Leveler | 1.0 | 2.1 | 66 | 31 | 380 | 20 | 13 |
| | 21 | 95 | 530 | 1 | Light Rolling | 0.8 | 1.2 | 49 | 23 | 300 | 80 | 48 |
| | 22 | 91 | 340 | 55 | Buff Polishing | 1.7 | 2.2 | 39 | 21 | 270 | 95 | 41 |
| | 23 | 87 | 620 | 0.1 | Tension Leveler | 1.7 | 3.3 | 57 | 18 | 520 | 1 | 36 |
| | 24 | 86 | 510 | 1 | Light Rolling | 2.4 | 3.6 | 43 | 14 | 400 | 10 | 17 |
| Comparative Examples | 1 | 91 | 460 | 4 | Buff Polishing | 0.9 | 1.7 | 65 | 36 | 280 | 95 | 22 |
| | 2 | 98 | 590 | 0.5 | Tension Leveler | 0.1 | 0.4 | 84 | 38 | 530 | 1 | 8 |
| | 3 | 87 | 390 | 10 | Light Rolling | 2.1 | 3.0 | 46 | 21 | 400 | 10 | 27 |
| | 4 | 87 | 410 | 10 | Buff Polishing | 0.8 | 2.3 | 81 | 42 | 450 | 5 | 20 |
| | 5 | 93 | 580 | 0.5 | Tension Leveler | 0.5 | 1.5 | 77 | 30 | 540 | 1 | 22 |
| | 6 | 87 | 320 | 70 | Light Rolling | 1.0 | 3.3 | 74 | 12 | 340 | 55 | 70 |

[Table 5]

| | | Multi-Gauge Strip | | | Evaluation | | | | | | |
|---|---|---|---|---|---|---|---|---|---|---|---|
| | | Sheet Thickness in Thin Portion mm | Sheet Thickness in Thick Portion mm | Thick Portion/Thin Portion % | S Orientation | | ODF | | Electrical Conductivity % IACS | Heatproof Temperature | |
| | | | | | Thick Portion % | Thin Portion % | Thick Portion | Thin Portion | | Thick Portion °C | Thin Portion °C |
| Invention Examples | 1 | 0.6 | 1.6 | 267 | 3.9 | 3.9 | 3.8 | 3.9 | 99.6 | 260 | 260 |
| | 2 | 0.6 | 0.7 | 117 | 2.7 | 2.8 | 5.1 | 5.0 | 99.4 | 283 | 281 |
| | 3 | 2.0 | 2.9 | 145 | 2.0 | 2.1 | 6.9 | 6.8 | 99.3 | 314 | 311 |
| | 4 | 1.0 | 2.4 | 240 | 1.2 | 1.3 | 9.3 | 9.2 | 99.2 | 336 | 335 |
| | 5 | 1.4 | 2.5 | 179 | 0.1 | 0.2 | 14.3 | 14.3 | 97.1 | 385 | 386 |
| | 6 | 0.9 | 2.8 | 311 | 0.3 | 0.3 | 13.4 | 13.3 | 97.7 | 381 | 383 |
| | 7 | 1.2 | 3.6 | 300 | 0.6 | 0.7 | 11.5 | 11.5 | 98.2 | 365 | 364 |
| | 8 | 2.3 | 4.1 | 178 | 0.9 | 1.0 | 10.0 | 10.2 | 98.9 | 359 | 358 |
| | 9 | 1.9 | 2.9 | 153 | 3.8 | 3.9 | 1.32 | 1.34 | 98.8 | 263 | 264 |
| | 10 | 1.5 | 2.1 | 140 | 3.0 | 3.1 | 1.9 | 1.8 | 98.7 | 285 | 285 |
| | 11 | 0.8 | 1.9 | 238 | 2.2 | 2.3 | 2.2 | 2.2 | 98.9 | 309 | 310 |
| | 12 | 2.0 | 2.0 | 100 | 1.7 | 1.8 | 2.6 | 2.6 | 99.3 | 320 | 321 |
| | 13 | 0.3 | 0.7 | 233 | 1.0 | 1.0 | 3.1 | 3.2 | 98.4 | 350 | 352 |
| | 14 | 0.7 | 0.9 | 129 | 1.3 | 1.4 | 19.8 | 19.7 | 99.2 | 338 | 336 |
| | 15 | 2.0 | 2.6 | 130 | 1.3 | 1.2 | 16.4 | 16.2 | 99.0 | 334 | 333 |
| | 16 | 1.1 | 1.4 | 127 | 1.1 | 1.1 | 15.1 | 15.0 | 99.0 | 351 | 349 |

[Table 6]

| | | Multi-Gauge Strip | | | Evaluation | | | | | | | |
|---|---|---|---|---|---|---|---|---|---|---|---|---|
| | | Sheet Thickness in Thin Portion mm | Sheet Thickness in Thick Portion mm | Thick Portion/Thin Portion % | S Orientation | | ODF | | Electrical Conductivity % IACS | Heatproof Temperature | |
| | | | | | Thick Portion % | Thin Portion % | Thick Portion | Thin Portion | | Thick Portion °C | Thin Portion °C |
| Invention Examples | 17 | 2.7 | 3.2 | 119 | 0.9 | 0.9 | 13.2 | 13.3 | 99.0 | 350 | 350 |
| | 18 | 3.6 | 5.0 | 139 | 0.7 | 0.8 | 13.8 | 13.7 | 98.9 | 355 | 356 |
| | 19 | 0.1 | 0.7 | 700 | 4.1 | 0.5 | 3.5 | 15.8 | 99.3 | 352 | 325 |
| | 20 | 0.9 | 1.8 | 200 | 1.2 | 1.1 | 14.2 | 14.3 | 98.6 | 361 | 360 |
| | 21 | 0.4 | 0.6 | 150 | 9.7 | 9.6 | 4.5 | 4.4 | 99.3 | 262 | 263 |
| | 22 | 1.0 | 1.3 | 130 | 7.4 | 7.3 | 5.5 | 5.6 | 98.5 | 280 | 281 |
| | 23 | 1.1 | 2.1 | 191 | 4.8 | 4.9 | 5.8 | 6.0 | 99.0 | 313 | 312 |
| | 24 | 2.0 | 3.0 | 150 | 1.6 | 1.4 | 10.6 | 10.7 | 98.9 | 358 | 360 |
| Comparative Examples | 1 | 0.7 | 1.3 | 186 | 2.5 | 2.3 | 9.9 | 10.0 | 99.8 | 185 | 183 |
| | 2 | 0.1 | 0.4 | 400 | 3.2 | 0.8 | 4.6 | 13.9 | 80.4 | 425 | 393 |
| | 3 | 1.5 | 2.2 | 147 | 4.5 | 4.4 | 1.5 | 1.4 | 98.8 | 200 | 203 |
| | 4 | 0.6 | 1.8 | 300 | 5.1 | 5.0 | 1.6 | 1.6 | 99.6 | 208 | 209 |
| | 5 | 0.4 | 1.2 | 300 | 2.8 | 2.6 | 0.4 | 0.4 | 99.2 | 222 | 221 |
| | 6 | 0.3 | 1.0 | 333 | 15.6 | 15.5 | 8.7 | 8.5 | 98.4 | 225 | 227 |

In Comparative Example 1, since the amount of Mg was less than the range of the present invention, the heatproof temperature was low and the heat resistance was insufficient.

In Comparative Example 2, the amount of Mg was greater than the range of the present invention, and the electrical conductivity was low.

In Comparative Example 3, the total amount of S, P, Se, Te, Sb, Bi, and As was greater than 30 mass ppm, the heatproof temperature was low, and the heat resistance was insufficient.

In Comparative Example 4, the mass ratio [Mg]/[S + P + Se + Te + Sb + Bi + As] was less than 0.6, the heatproof temperature was low, and the heat resistance was insufficient.

In Comparative Example 5, the average value of the orientation densities at $\varphi_2 = 0°$, in a range of $\varphi_1 = 0°$ to $20°$, and in a range of $\Phi = 35°$ to $55°$ was less than 1.3, the heatproof temperature was low, and the heat resistance was insufficient.

In Comparative Example 6, the area ratio of crystals having a crystal orientation of 10° or less with respect to the S orientation {123}<634> was greater than 10%, the heatproof temperature was low, and the heat resistance was insufficient.

On the contrary, in Invention Examples 1 to 24, the electrical conductivity and the heat resistance were confirmed to be improved in a well-balanced manner.

Therefore, according to the invention examples, it was confirmed that a copper alloy having a high electrical conductivity and excellent heat resistance can be provided.

[Industrial Applicability]

It is possible to provide a copper alloy, a plastically-worked copper alloy material, a component for electronic and electrical devices, a terminal, a bus bar, a lead frame, and a heat dissipation substrate, which have a high electrical conductivity and excellent heat resistance.

[Reference Signs List]

10: Plastically-worked copper alloy material
11: Thick portion
12: Thin portion
t1: Thickness of thick portion 11
t2: Thickness of thin portion 12

**Claims**

1. A copper alloy having a composition comprising Mg in an amount of greater than 10 mass ppm and 100 mass ppm or less with a balance being Cu and inevitable impurities,

   wherein in the inevitable impurities, an amount of S is 10 mass ppm or less, an amount of P is 10 mass ppm or less, an amount of Se is 5 mass ppm or less, an amount of Te is 5 mass ppm or less, an amount of Sb is 5 mass ppm or less, an amount of Bi is 5 mass ppm or less, an amount of As is 5 mass ppm or less, and a total amount of S, P, Se, Te, Sb, Bi, and As is 30 mass ppm or less,
   when the amount of Mg is indicated as [Mg] and the total amount of S, P, Se, Te, Sb, Bi, and As is indicated as [S + P + Se + Te + Sb + Bi + As], a mass ratio thereof [Mg]/[S + P + Se + Te + Sb + Bi + As] is in a range of 0.6 or greater and 50 or less,
   an electrical conductivity is 97% IACS or greater,
   when a crystal orientation distribution function obtained from texture analysis by an EBSD method is expressed in terms of Euler angles, an average value of orientation densities at $\varphi2 = 0°$, in a range of $\varphi1 = 0°$ to 20°, and in a range of $\Phi = 35°$ to 55° is 1.3 or greater and less than 20.0, and
   an area ratio of crystals having a crystal orientation of 10° or less with respect to an S orientation {123 } <634> is 10% or less.

2. The copper alloy according to Claim 1,
   wherein an amount of Ag is in a range of 5 mass ppm or greater and 20 mass ppm or less.

3. The copper alloy according to Claim 1 or 2, wherein a heatproof temperature is 260°C or higher.

4. A plastically-worked copper alloy material comprising: the copper alloy according to any one of Claims 1 to 3.

5. The plastically-worked copper alloy material according to Claim 4, which is a multi-gauge strip.

6. The plastically-worked copper alloy material according to Claim 4 or 5, further comprising:
   a metal plating layer on a surface.

7. A component for electronic and electrical devices comprising:
   the plastically-worked copper alloy material according to any one of Claims 4 to 6.

8. A terminal comprising:
   the plastically-worked copper alloy material according to any one of Claims 4 to 6.

9. A bus bar comprising:
   the plastically-worked copper alloy material according to any one of Claims 4 to 6.

10. A lead frame comprising:
    the plastically-worked copper alloy material according to any one of Claims 4 to 6.

11. A heat dissipation substrate comprising:
    the plastically-worked copper alloy material according to any one of Claims 4 to 6.

FIG. 1

# FIG. 2

```
┌─────────────────────────────┐
│  MELTING AND CASTING STEP   │──── S01
└─────────────────────────────┘
              │
              ▼
     ╭─────────────────────╮
     │        INGOT        │
     ╰─────────────────────╯
              │
              ▼
┌─────────────────────────────┐
│      HOMOGENIZING/          │──── S02
│    SOLUTIONIZING STEP       │
└─────────────────────────────┘
              │
              ▼
┌─────────────────────────────┐
│     ROUGH WORKING STEP      │──── S03
└─────────────────────────────┘
              │
              ▼
┌─────────────────────────────┐
│     INTERMEDIATE HEAT       │──── S04
│      TREATMENT STEP         │
└─────────────────────────────┘
              │
              ▼
┌─────────────────────────────┐
│    MECHANICAL SURFACE       │──── S05
│      TREATMENT STEP         │
└─────────────────────────────┘
              │
              ▼
┌─────────────────────────────┐
│   MULTI-GAUGE ROLLING STEP  │──── S06
└─────────────────────────────┘
              │
              ▼
┌─────────────────────────────┐
│   HEAT TREATMENT BEFORE     │──── S07
│      FINISHING STEP         │
└─────────────────────────────┘
              │
              ▼
┌─────────────────────────────┐
│    FINISH WORKING STEP      │──── S08
└─────────────────────────────┘
              │
              ▼
   ╭───────────────────────────────╮
   │ COPPER ALLOY(PLASTICALLY-WORKED│
   │    COPPER ALLOY MATERIAL)      │
   ╰───────────────────────────────╯
```

## INTERNATIONAL SEARCH REPORT

| International application No. |
|---|
| **PCT/JP2022/048118** |

### A. CLASSIFICATION OF SUBJECT MATTER

**C22C 9/00**(2006.01)i; **C22F 1/00**(2006.01)i; **C22F 1/08**(2006.01)i
FI:     C22C9/00; C22F1/00 606; C22F1/00 612; C22F1/00 613; C22F1/00 623; C22F1/00 650A; C22F1/00 651Z; C22F1/00 661A; C22F1/00 681; C22F1/00 682; C22F1/00 683; C22F1/00 685A; C22F1/00 685Z; C22F1/00 686A; C22F1/00 691B; C22F1/00 691C; C22F1/00 694A; C22F1/00 694B; C22F1/00 694Z; C22F1/08 B

According to International Patent Classification (IPC) or to both national classification and IPC

### B. FIELDS SEARCHED

Minimum documentation searched (classification system followed by classification symbols)

C22C9/00; C22F1/00; C22F1/08

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2003-136103 A (MITSUBISHI SHINDOH CO., LTD.) 14 May 2003 (2003-05-14)<br>entire text, all drawings | 1-11 |
| A | JP 2021-55129 A (MITSUBISHI MATERIALS CORP.) 08 April 2021 (2021-04-08)<br>entire text, all drawings | 1-11 |
| A | WO 2021/117698 A1 (MITSUBISHI MATERIALS CORP.) 17 June 2021 (2021-06-17)<br>entire text, all drawings | 1-11 |
| A | WO 2020/203576 A1 (MITSUBISHI MATERIALS CORP.) 08 October 2020 (2020-10-08)<br>entire text, all drawings | 1-11 |
| A | JP 2020-128598 A (MITSUBISHI MATERIALS CORP.) 27 August 2020 (2020-08-27)<br>entire text, all drawings | 1-11 |
| P, A | JP 2022-69413 A (MITSUBISHI MATERIALS CORP.) 11 May 2022 (2022-05-11)<br>entire text, all drawings | 1-11 |

☐ Further documents are listed in the continuation of Box C.      ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **03 March 2023** | **20 March 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT

Information on patent family members

International application No.

**PCT/JP2022/048118**

| Patent document cited in search report | | | Publication date (day/month/year) | Patent family member(s) | | | Publication date (day/month/year) |
|---|---|---|---|---|---|---|---|
| JP | 2003-136103 | A | 14 May 2003 | (Family: none) | | | |
| JP | 2021-55129 | A | 08 April 2021 | US | 2022/0341000 | A1 | |
| | | | | entire text, all drawings | | | |
| | | | | WO | 2021/060013 | A1 | |
| | | | | EP | 4036260 | A1 | |
| | | | | CN | 114302975 | A | |
| WO | 2021/117698 | A1 | 17 June 2021 | EP | 4074848 | A1 | |
| | | | | entire text, all drawings | | | |
| | | | | CN | 114641585 | A | |
| | | | | KR | 10-2022-0113408 | A | |
| WO | 2020/203576 | A1 | 08 October 2020 | US | 2022/0145424 | A1 | |
| | | | | entire text, all drawings | | | |
| | | | | EP | 3950980 | A1 | |
| | | | | CN | 113614258 | A | |
| | | | | KR | 10-2021-0144744 | A | |
| JP | 2020-128598 | A | 27 August 2020 | (Family: none) | | | |
| JP | 2022-69413 | A | 11 May 2022 | WO | 2022/085723 | A1 | |
| | | | | entire text, all drawings | | | |

Form PCT/ISA/210 (patent family annex) (January 2015)

**EP 4 458 999 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021214029 A

- JP 2016056414 A